(19) **Europäisches Patentamt / European Patent Office / Office européen des brevets**

(11) **EP 1 804 565 A1**

(12) # EUROPEAN PATENT APPLICATION
published in accordance with Art. 158(3) EPC

(43) Date of publication:
**04.07.2007 Bulletin 2007/27**

(51) Int Cl.:
**H05K 9/00** (2006.01)

(21) Application number: **04769785.9**

(22) Date of filing: **27.07.2004**

(86) International application number:
**PCT/IB2004/051296**

(87) International publication number:
**WO 2006/013402 (09.02.2006 Gazette 2006/06)**

(84) Designated Contracting States:
**AT BE BG CH CY CZ DE DK EE ES FI FR GB GR HU IE IT LI LU MC NL PL PT RO SE SI SK TR**

(71) Applicant: **Advanced Shielding Technologies Europe S.L.**
**08940 Cornella de Llobregat (ES)**

(72) Inventor: **DAUNERT ARMILLAS, Enrique, AST**
**E-08940 Cornellà de Llobregat (ES)**

(74) Representative: **Müller Fottner Steinecke Rechtsanwälte Patentanwälte,**
**Postfach 31 01 40**
**80102 München (DE)**

(54) **SHIELDED ENCLOSURE FOR ELECTROMAGNETIC FIELDS**

(57)    The present invention relates to a smart shelter providing a flexible, quick and efficient solution to companies and private persons having a growing concern regarding their data network security/control. The smart shelter is a reliable solution, it can be fitted easily and rapidly and it is able to comply with major requirements providing protection/prevention against the majority of the above mentioned risk factors. In comparison with other more conventional systems of building data storage facilities, the smart shelter provides the following advantages: 1) electromagnetic protection against electrical fields, 2) electromagnetic protection against magnetic fields, 3) modular structure having excellent behaviour against fire (RF120) and integrity against smoke and water (IP67). It's major advantages are: 1) a smart shelter has been designed specifically for data storage facilities, 2) it is a perfectly designed solution integrating all the above mentioned features, 3) it has already been implemented successfully in the past in other facilities, 4) it is a fully integrated facility delivered turnkey, 5) the project management has been given to and completed by highly qualified staff, 6) one only person is in charge of the whole project, 7) the certificate of conformity complies with the application standards.

CONVENTIONAL STRUCTURE VS. SMART SHELTER STRUCTURE

Flames > 1100°C

Flames > 1100°C

Figure no. 11

**Description**

**I. Technical Field:**

'SMART SHELTER' is the application relating to data storage rooms *(I.T. Rooms)*.

**II. Background:**

'SMART SHELTER' originated to provide a flexible, quick and effective solution to companies and individuals given the grown concern for the security/control of their data networks. According to various studies, it has been demonstrated that 90% of the companies that lose all their data go bankrupt in less than 12 months (source HP, Swiss Re, ...).
The principal risk factors in a DPC are the following:

Natural:
Flood
Fire
Heat
Storms
Earthquakes
Human:
Electromagnetic Fields (transformation centres, power distribution trays, ...)
Power Outages
Vandalism
Unintentional Human Error
Sabotage/Terrorism
Data Networks:
Network Saturation (IP conflicts, ...)
Hackers and Virus

The 'SMART SHELTER' is a reliable solution of easy and quick installation that is capable of responding to the greatest demands, offering protection/prevention against the majority of the risk factors listed above.

**III. Description of the invention: 'SMART SHELTER'**

In comparison with other more traditional systems of constructing data storage rooms, the **'SMART SHELTER'** presents the following advantages:

**1. Electromagnetic Protection for Electric Fields:**

Thanks to its exclusive protection, the **'SMART SHELTER'** permits reducing to levels of around 10 dB the electrical fields of direct exposure. As an example, a traditional data storage room, located 6 m from an electrical field source (in this case a broadcasting antenna operating at 0.9 GHz) would receive a maximum exposure of around 10 V/m; on the contrary with the shielding technology of the **'SMART SHELTER'**, the maximum electrical field incidence would not be over 3.5 V/m. The **'SMART SHELTER'** is effective for any electrical field source, independently of its power and/or frequency and independently also of the proximity of the source.

*a) Description and characteristics:*

As can be seen in the following theoretical EXPOSITION, the intensity of the field (V/m) mostly depends on the power and frequency of the emitting source. *(See AST-formula I.).*

$$WD_r = (W_T - G_T)/4\ r^2 \qquad \text{FORMULA I}$$

Where:

$WD_r$: Density of power in the point of study (W/m$^2$)
$W_T$ : Power of the broadcasting antenna (W)
$G_T$ : Gain in the broadcasting antenna

r: distance (m)

$$E^2 = WD_r^2 Z_0$$

Where:

E: Electrical field in the point of study (V/m)
$Z_0$: Impedance of the air (120)

The shielding of the 'SMART SHELTER' is based on the principle of reflection of electrical fields. This principle states that the more conductive a surface is, the more it will reflect a radio wave falling on it; and therefore, it will reduce the level of the electrical field.

If the surface is partially covered by a shield of conductive materials (i.e., Copper, Nickel, Silver...) there will be a certain lessening of the electrical field.

The more extensive, complete, uniform, dense and closed (to avoid the entrance of electrical field waves) is this shield, the greater shall be the level of reduction achieved (see the attached figure).

*a) Principal Advantages of the Reduction of the Electrical Field Levels:*

*Equipment:* It creates a more favourable setting for the electronic and computer equipment and machines exposed directly to this field, since in many cases it reduces and adapts the electrical field levels in the atmosphere to the maximum levels of immunity required by the international guidelines of Electromagnetic Compatibility (i.e., **EEC/89/336,** ...) and specifically international standards of immunity to Electrical Fields (i.e., **IEC/EN 61000-4-3**), guaranteeing in this way the perfect functioning of this equipment against the proximity of such a source of emission.

*Persons:* It reduces the exposure level of the Electrical Field of persons, so that they adapt to the levels that can be found in an open field, with the consequent psychological benefit for the persons exposed and also the possible physical benefit, according to different medical studies.

## 1. Electromagnetic protection for Magnetic Fields:

Thanks to its exclusive protection, the 'SMART SHELTER' permits reducing to levels less than **37.5 mG** according to the European standard **IEC/EN 6100-4-8**. In addition to this standard, there are many studies that recommend lower field levels (**NCRM** 10 mG; **MPRII** 2.5 mG, ...).

*The criterion of **AST** is to adopt the **10 mG** as the security limit for persons and equipment.*

The principal magnetic field sources are usually related to the transmission of electrical power; these sources are:

• Transformer Centres

• Electrical power switches

• Power cables

• Other equipment:

> o High-powered air conditioners
> o SAI's
> o Generating Systems

*a) Description and characteristics:*

The magnetic shielding is based on the physical principle of magnetisation/demagnetisation known as the "Hysteresis Cycle"; but specifically in the part of the curve in which the ferromagnetic materials are magnetised.

What one wants to achieve is to "line" the walls of the 'SMART SHELTER' with a material of high magnetic permeability (SIFE, MuMetal, ...) so that the lines of magnetic field coming from the emitting source are 'absorbed' in this lining and do not penetrate in the interior of the 'SMART SHELTER', protecting in this way the persons/equipment located therein.

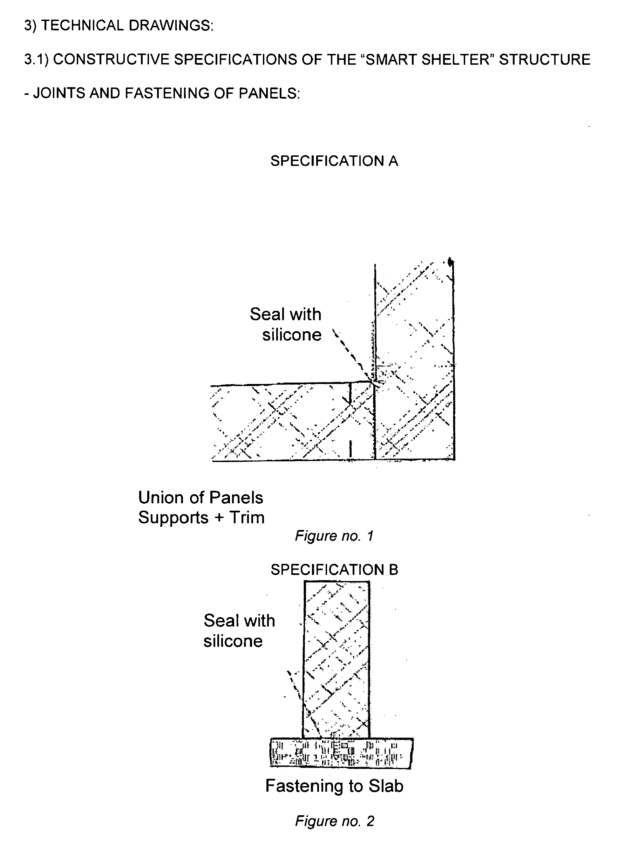

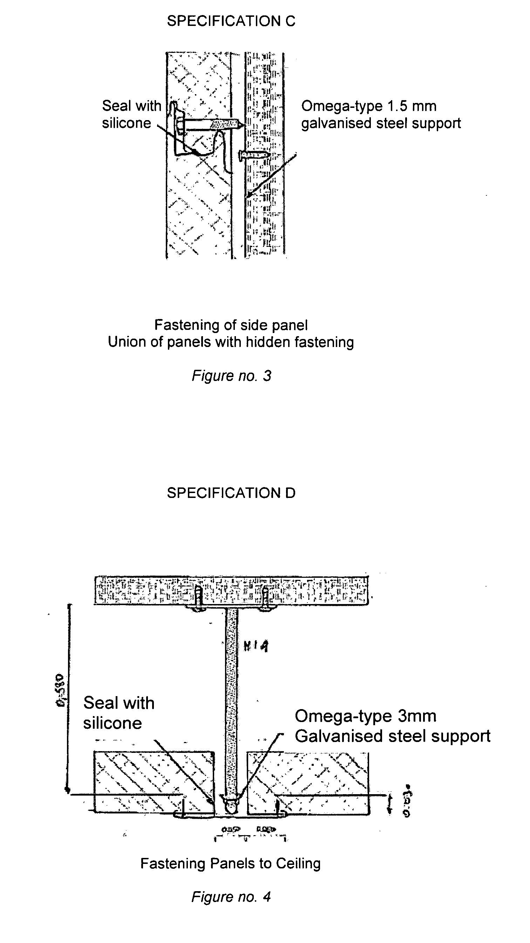

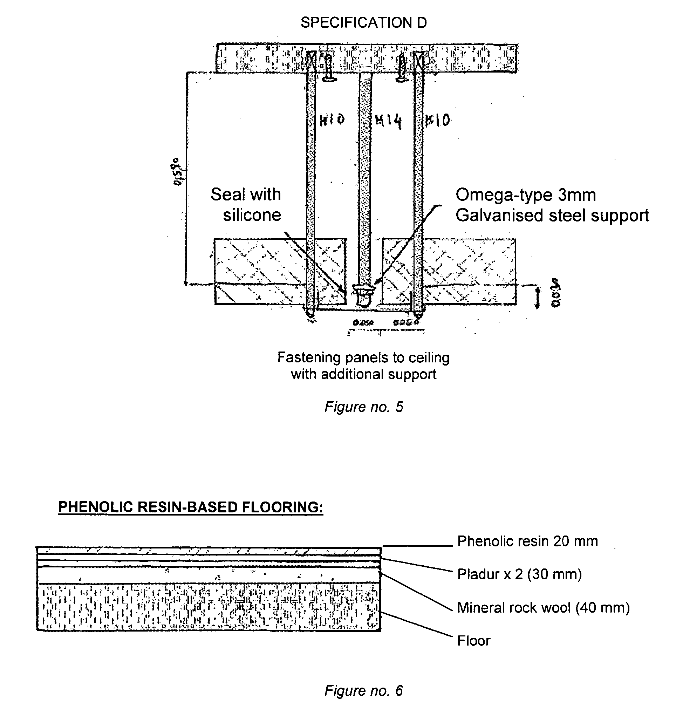

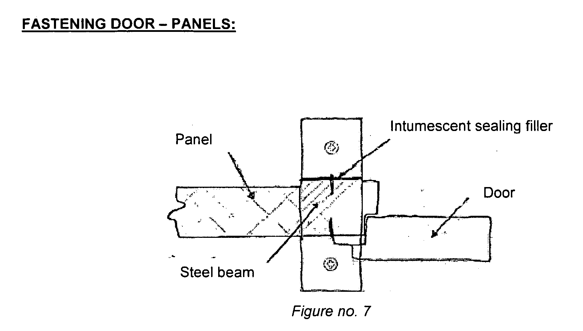

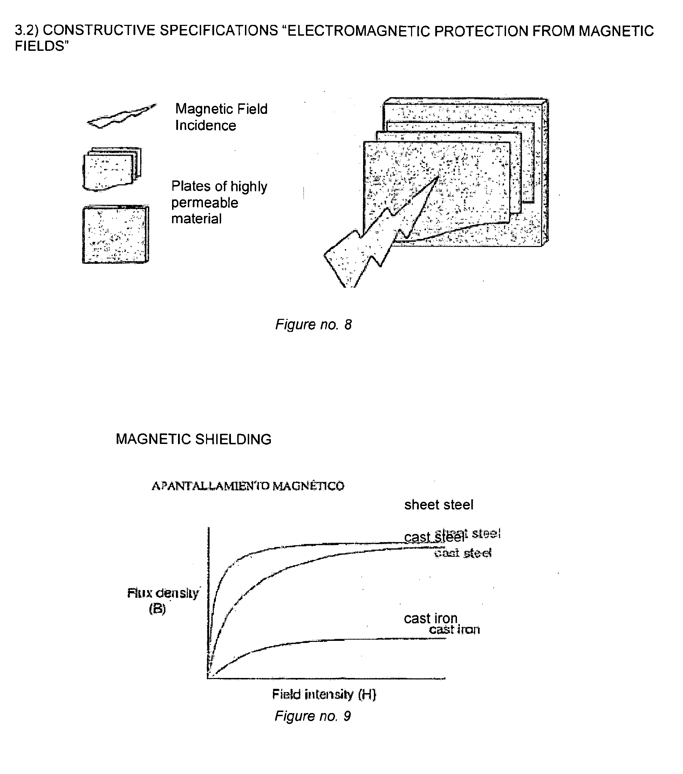

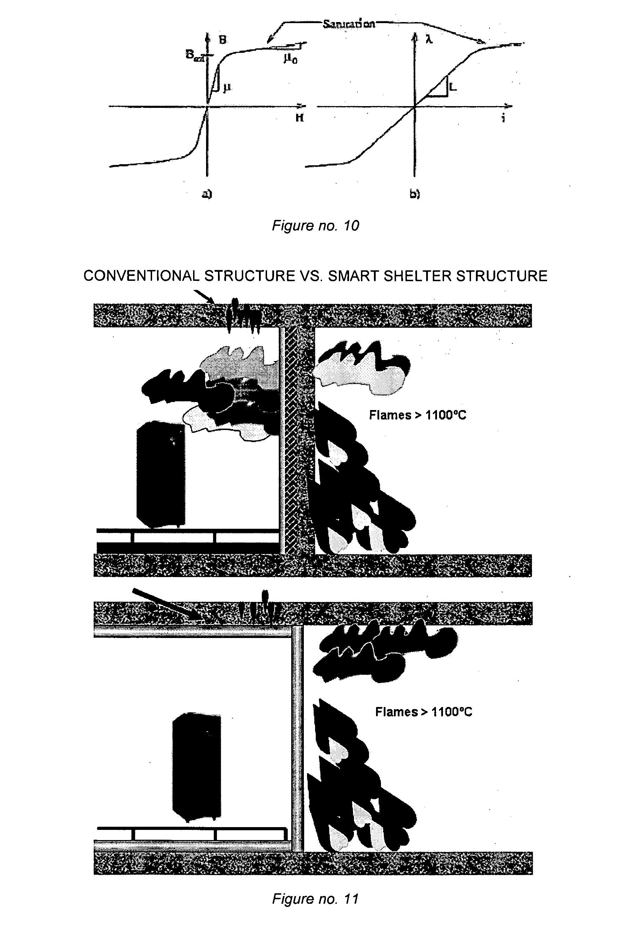

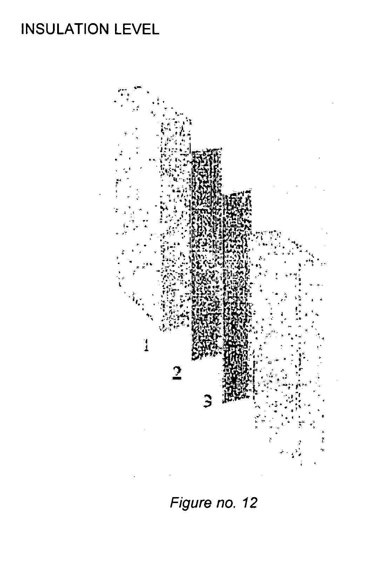

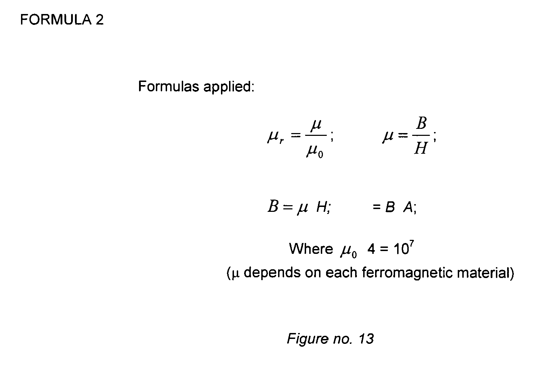

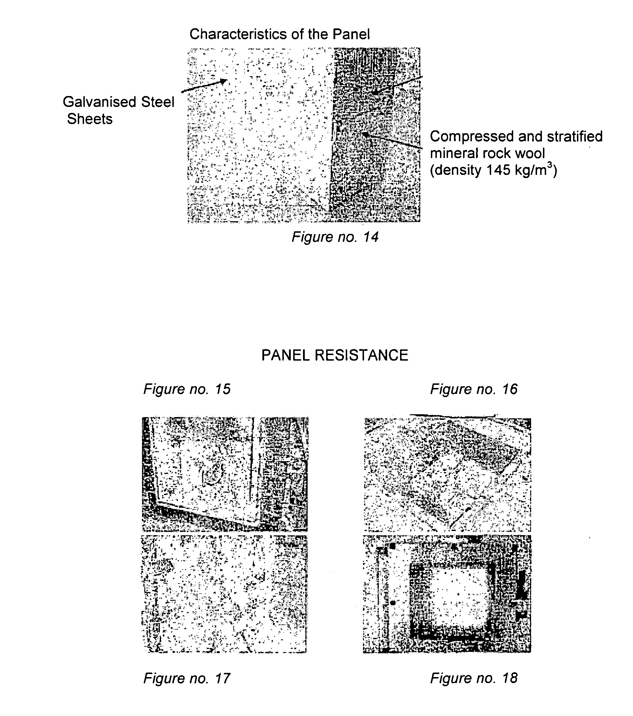

As can be seen in *the Figure 9 "MAGNETIC SHIELDING"* (in *Drawings*) from a certain intensity of field (H) one arrives at a point ('Saturation Bend') from which regardless of how elevated is H, the density of flow (B) that crosses the ferromagnetic material (number of magnetic field lines that cross the material) scarcely increases; we have reached a Saturation area of the materials.

For practical purposes, this means that if the Intensity of the Magnetic Field (H) is sufficiently elevated it is not enough to install a ferromagnetic material. This is due to the fact that when this reaches its saturation area, it can no longer absorb more field lines.

Also see Figure 11 of *'CONVENTIONAL STRUCTURE VS SMART SHELTER STRUCTURE' in Drawings.*

See Formulas of application in *AST-Formula 2:*

FORMULA 2

Applied formulas:

$$\mu_r = \frac{\mu}{\mu_0}; \quad \mu = \frac{B}{H};$$

$$B = \mu H; \qquad = B \ A;$$

Where $\mu_0$ $4 = 10^7$

($\mu$ depends on each ferromagnetic material)

This (saturation of ferromagnetic materials) and many other problems have been resolved, obtaining some highly satisfactory results in different installations.

The process followed in providing effective shielding is the following:

*First:* The perimeter of the '**SMART SHELTER**' is covered with plates of ferromagnetic material. The number of layers to install varies (between 1 and 8 layers, 0.5 mm thick) according to the characteristics of the location (distance to the emitting source, strength of the emitting source,...). The material used is silicon steel SIFE (Iron - Silicon Alloy with high permeability and elevated saturation point) of the following magnetic characteristics:

**Composition (%)**
*Fe-97*
*Si-3*
**Permeability (20 Gauss)**
*1,500*
**Maximum permeability**
*30,000*
**Saturation flow density**
*20,000*

*Second:* As mentioned above, all ferromagnetic material reaches a point in which it is saturated and cannot absorb more flow from the field.

Thanks to the exclusive shielding technology used in the **'SMART SHELTER',** it uses a final layer of Aluminium that is located in the entire perimeter to protect. This layer guarantees that the residual flow that the first layers of SIFE cannot absorb does not penetrate the shield. This occurs because the aluminium is a *para-magnetic* material of very high susceptibility ($7.7 \cdot 10^9$ m3/kg; the susceptibility is the electrical equivalent to resistance, the more susceptibility a material has, the more difficult it is that it becomes magnetised). This last layer functions as a type of shield, not allowing passage of the residual flow that the SIFE had not been able to absorb.

*Third:* In order to guarantee to a greater extent the effectiveness of the shielding, both layers are welded (SIFE, Aluminium). This welding 'covers' possible spaces and weak points of the structure.

Argon is used as the gas and a cord of higher-quality aluminium (purity, A199.999%) than that used in the previous layer is welded.

See *figure 8 'CONSTRUCTIVE SPECIFICATIONS OF ELECTROMAGNETIC PROTECTION. MAGNETIC FIELDS' in Drawings.*

NOTE: The first layer of SIFE is always applied on the face most exposed to the magnetic field source.

a) *Advantages:*

As already mentioned, according to the latest version of the **EMC/CEM** regulation (ElectroMagnetic Compatibility / Compatibilidad Electro-Magnética) applicable to I.T., scientific and critical environment equipment, the magnetic field levels that must be met are of **37.5 mG**, in order to ensure its correct functioning (**IEC 61000-4-8**).

With this type of assembly (SIFE - Aluminium) shielding is achieved of up to **35 dB**; reducing the field levels to under the **10 mG** (security limit recommended by AST).

Being under the 10 mG assures a more correct operation for the equipment installed inside the **'SMART SHELTER'** as well as a healthy work environment for the persons working therein.

**1. Structural Panel:**

As mentioned above, the **'SMART SHELTER'** is an alterative to the more traditional methods of construction.

Traditionally the rooms dedicated to data storage were enclosed with concrete walls. This system presents the following disadvantages:

- Although a 150-cm thick wall offers good performance regarding resistance to fire, its thermal stability is not as good as one would wish.
- This type of construction involves a higher cost, execution time (drying of materials,...), a larger number of workers, generation of dirt (powder, residue,...).
- Concrete needs finishing work (paint, ...)
- Concrete, by being porous, contains a high level of water. If the concrete wall is exposed to high temperatures, small drops of water, moisture, ... can appear through condensation in

the interior of the protected room, with the consequent risk of short circuits.

Alternatively, enclosing the room with the exclusive technology of the **'SMART SHELTER'** presents the following advantages:

- Rapid and easy assembly (lighter materials and easy to install).
- Cleaning.
- Different types of finishes.
- Great structural rigidity.
- Modularity.
- High resistance to fire.

See *figure 11 'CONVENTIONAL STRUCTURE VS. SMART SHELTER STRUCTURE' in Drawings.*

All these advantages are obtained thanks to the special type of panel used for its construction.

a) *Description and characteristics of panel:*

It consists of a panel formed by two layers of galvanized steel (80% of ferrite) with a thickness of 1 mm, of variable exterior size (as needed, from 1.1 m in width up to 12 m in breadth). The outside part comes from the factory lacquered on the exterior part in either white or metallic grey. This panel comes filled with a fireproof mineral fibre pressed at 20 Tn (achieving a density of 145 kg/m$^3$) and stratified until it forms a compact mass 100 mm thick.

The ends of each panel come finished in the shape of a 'U', forming a "male-female" system that fit together through pressure upon alternatively assembling each of the panels that make up the general structure.

The weight of each panel varies according to its thickness, this being around 23 kg/m$^2$ for 100 mm (standard thickness for obtaining an **RF120**). According to this, different RF's can be obtained (see table *below*):

| Thickness (mm) | Weight (kg/m2) | RF (min) |
|---|---|---|
| 50 | 15.8 | 30 |
| 80 | 20.2 | 60 |
| 100 | 23.1 | 120 |
| 150 | 30.3 | > 120 |
| 200 | 37.6 | 180 |

For joining the panels, 'male-female' joints for a perfect seal of the joint.

Compressed and stratified mineral rock wool (density 145 gk/m$^3$).

Galvanised steel sheets.

*Fire resistance of the panel:* As mentioned above, one of the principal advantages of these panels is their tremendous performance against fire. For a given thickness of 100 mm, they guarantee a RF120 (120 minutes of fire resistance) according to **EN/UNE 23802**. The panels also comply with the **DIN 4102** standard that establishes a maximum temperature inside the room below 200°C. As an additional measure, in each and every one of the joints between panels, an intumescent material is applied (which increases its volume in the presence of heat). This material, of a density of 1,400 g/dm$^3$ and reaction to fire M1 offers a passive resistance to fire of up to 120 minutes (RF 120), this intumescent filler has been tested in official laboratories according to the **UNE 23.093-81** standard.

*Watertight integrity:* Thanks to the zero-capillarity of the mineral rock wool of which the panels are comprised, together with the special form of joining them (male-female); a high level of watertight integrity is assured, thus avoiding problems caused by floods.

*a) Principal Advantages:*

Finally, and in summary, the principal advantages that the '**SMART SHELTER**' solution contributes regarding structural panelling are:

    i. Speed/ease/modularity in installation
    ii. Great structural rigidity
    iii. Great resistance to fire (according to **EN/UNE 23802**). It includes:

        a. Stability to fire
        b. Low reaction to fire
        c. No emission of inflammable gases
        d. High level of thermal resistance

    iv. High level of acoustic resistance (**NBE CPA-96**)
    v. Very low moisture/weight ratio at <0.60% (it avoids appearance of drops from condensation in case of fire, thus impeding possible short circuits,...).

**1. Joints and Seals of panels:**

Thanks to its exclusive sealing system, the '**SMART SHELTER**' achieves very high levels of watertight integrity (IP67).

*a) Description and characteristics:*

In order to achieve such a level of insulation, you do the following, See *figure* 12 *in 'INSULATION LEVEL' in Drawings:*

    Prior to mechanical anchoring of the panels, you **first** join them with silicone (2), this special silicone (fireproof and waterproof, resistant to corrosion and dust resistant) guarantees the watertight integrity of the room against water and air/smoke (also offering an additional protection from fire).
    Then a **second** layer of intumescent filler (3) (of the same type described above) in the outside part of the joint in order to guarantee appropriate protection against fire as well as to guarantee to a greater extent the watertight

6

integrity of the room.

To finish, the *third* joint is a strip (profile) of lacquered and riveted aluminium 1.5 mm thick that covers the union of the two panels, giving the structure greater structural rigidity and a quality finish (this last strip is also applied with silicone).

(1) Mineral rock wool

b) *Advantages:*

This joint system is clean, more economic than other sealing methods, easy to apply and it guarantees total watertight integrity, preserving the fire resistance of the joints in the two following ways:

The intumescent filler increases in volume in presence of heat, completely sealing the joint.

Not letting air pass between the joints.

**2. Phenolic resin-base flooring:**

In order to ensure a correct performance regarding the protection against fire and water, AST has developed a type of special modular flooring of easy installation.

a) *Description and characteristics:*

This flooring consists of a double 92-mm layer comprised of:

Layer of compressed and stratified natural mineral fibres with density of 150 kg/m$^3$ (40 mm) $\times$ 2.

A second 12-mm thick layer formed by two layers of MDF-type phenolic resin (M1 to Not inflammable) of great resistance to distortion in traction (0.65 N/mm$^2$) as well as in flexing 27 N/mm$^2$) and density 830 kg/m$^3$ (see attached table).

The entire flooring (the joints) is sealed appropriately with fireproof and watertight silicone.

This flooring group provides great mechanical solidity, resistance to distortion and protection against fire and moisture.

b) *Principal Advantages:*

This exclusive flooring used in the '**SMART SHELTER**' offers the following advantages with respect to other more conventional solutions:

i. Easy installation

ii. Great structural rigidity

iii. Solid and compact base

iv. Fire protection

v. Total watertight integrity

vi. Reusable

vii. Modular, different thicknesses according to the number of layers (MDF, rock wool) according to customer's needs/specifications.

More economical.

**3. APPLICATION: Data storage rooms:**

As mentioned above in this document, the **'SMART SHELTER'** solution has been developed specifically for data storage rooms (Servers, *Racks*, *Patch Panels, Storage* of magnetic tapes, ...). Including and integrating:

Modular structural solution

ii. Heating/cooling
iii. Fire detection/extinction
iv. Flooring
v. Access control, CTV
vi. Alarm management (24x7)

*a) Principal Advantages:*

Below is presented a list of the principal advantages of the **'SMART SHELTER':**

The **'SMART SHELTER'** has been specifically developed for data storage rooms.
It is a perfectly analysed system that includes all that is mentioned above.
iii. It has been successfully installed previously in other installations.
iv. It is a turn-key installation.
v. Dedicated project management carried out by highly qualified personnel.
vi. A single person in charge of the entire project.
vii. Certificate of conformity according to the application standards.

**Claims**

1.  AST, in relation to its fireproof, watertight and high-security enclosure called **'SMART SHELTER'**, claims the following:

    2.1) Thanks to its special sealing/fastening system of the joints and/or unions that form the structure, an exceptional performance against fire is attained (see *section 1*) Technical Description of the Invention).
    2.2) Thanks to the type of modular and fireproof flooring of its own design that complements the structure of the **'SMART SHELTER',** the entire room is made watertight.
    2.3) Its own technology regarding the shielding from electromagnetic field of both high and low frequencies, as well as its special form of integration with the rest of the **'SMART SHELTER'** structure

3) TECHNICAL DRAWINGS:

3.1) CONSTRUCTIVE SPECIFICATIONS OF THE "SMART SHELTER" STRUCTURE

- JOINTS AND FASTENING OF PANELS:

SPECIFICATION A

Seal with silicone

Union of Panels
Supports + Trim

Figure no. 1

SPECIFICATION B

Seal with silicone

Fastening to Slab

Figure no. 2

SPECIFICATION C

Seal with silicone

Omega-type 1.5 mm galvanised steel support

Fastening of side panel
Union of panels with hidden fastening

*Figure no. 3*

SPECIFICATION D

M14

Seal with silicone

Omega-type 3mm Galvanised steel support

Fastening Panels to Ceiling

*Figure no. 4*

SPECIFICATION D

Seal with
silicone

Omega-type 3mm
Galvanised steel support

Fastening panels to ceiling
with additional support

*Figure no. 5*

**PHENOLIC RESIN-BASED FLOORING:**

Phenolic resin 20 mm

Pladur x 2 (30 mm)

Mineral rock wool (40 mm)

Floor

*Figure no. 6*

**FASTENING DOOR – PANELS:**

*Figure no. 7*

3.2) CONSTRUCTIVE SPECIFICATIONS "ELECTROMAGNETIC PROTECTION FROM MAGNETIC FIELDS"

Magnetic Field Incidence

Plates of highly permeable material

*Figure no. 8*

MAGNETIC SHIELDING

APANTALLAMIENTO MAGNÉTICO

sheet steel

cast steel

Flux density (B)

cast iron

Field intensity (H)

*Figure no. 9*

Figure no. 10

CONVENTIONAL STRUCTURE VS. SMART SHELTER STRUCTURE

Figure no. 11

INSULATION LEVEL

*Figure no. 12*

FORMULA 2

Formulas applied:

$$\mu_r = \frac{\mu}{\mu_0}; \qquad \mu = \frac{B}{H};$$

$$B = \mu \ H; \qquad = B \ A;$$

Where $\mu_0$ $4 = 10^7$

($\mu$ depends on each ferromagnetic material)

*Figure no. 13*

Characteristics of the Panel

Galvanised Steel
Sheets

Compressed and stratified
mineral rock wool
(density 145 kg/m$^3$)

*Figure no. 14*

PANEL RESISTANCE

*Figure no. 15*                    *Figure no. 16*

*Figure no. 17*                    *Figure no. 18*

## INTERNATIONAL SEARCH REPORT

| International application No. |
| --- |
| PCT/ IB 2004/051296 |

**A. CLASSIFICATION OF SUBJECT MATTER**

CIP⁷ H05K 9/00

According to International Patent Classification (IPC) or to both national classification and IPC

**B. FIELDS SEARCHED**

Minimum documentation searched (classification system followed by classification symbols)

CIP⁷ H05K 9/00

Documentation searched other than minimum documentation to the extent that such documents are included in the fields searched

Electronic data base consulted during the international search (name of data base and, where practicable, search terms used)

OEPMPAT, EPODOC, WPI, PAJ, WORLD WIDE WEB.

**C. DOCUMENTS CONSIDERED TO BE RELEVANT**

| Category* | Citation of document, with indication, where appropriate, of the relevant passages | Relevant to claim No. |
| --- | --- | --- |
| Y | WO 03059030 A (4 D NEUROIMAGING et al.) 17.07.2003 **The whole document** | 1 |
| Y | WO 03091016 A (COPPOCK et al.) 06.11.2003, **Page 1, ligne 24** **Page 2, ligne 21** | 1 |
| Y | SEMANA INFORMÁTICA, n° 690, "IBM apresenta Data Shelter" (Luisa Dámaso) **April 2004** | 1 |
| A | ITS Newsletter, 10ª edidión (IBM) **March/April 2003, pages 3-5** | 1 |
| A | ITS Newsletter, 15ª edidión (IBM) **March/April 2004, pages 3,4** | 1 |

☐ Further documents are listed in the continuation of Box C.   ☒ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | |
| "O" document referring to an oral disclosure, use, exhibition or other means | "Y" document of particular relevance; the claimed invention cannot be considered to involve an inventive step when the document is combined with one or more other such documents, such combination being obvious to a person skilled in the art |
| "P" document published prior to the international filing date but later than the priority date claimed | "&" document member of the same patent family |

| Date of the actual completion of the international search | Date of mailing of the international search report |
| --- | --- |
| **03 December 2004**   (03.12.2004) | **10 December 2004** |
| Name and mailing address of the ISA/ | Authorized officer |
| Facsimile No. | Telephone No. |

Form PCT/ISA/210 (second sheet) (July 1992)

<div align="center">

**INTERNATIONAL SEARCH REPORT**
Information on patent family members

</div>

International Application No

PCT/ IB 2004/051296

| Patent document cited in search report | Publication date | Patent familiy member(s) | Publication date |
|---|---|---|---|
| WO 03059030 A | 17.07.2003 | CA 2472955 A<br>EP 1470746 A<br>EP 20030700013 | 17.07.2003<br>27.10.2004<br>03.01.2003 |
| WO 03091016 A | 06.11.2003 | IE 20030202 A<br>GB 2388339 A | 29.10.2003<br>12.11.2003 |

Form PCT/ISA/210 (patent family annex) (July 1992)